# DEMANDE DE BREVET EUROPEEN

(11) **EP 1 211 811 A1**
(43) Date de publication de la demande: **05.06.2002**
(21) Numéro de dépôt: 01204455.8
(22) Date de dépôt: 22.11.2001
(51) Int. Cl.: H03L 7/085, H03D 13/00, H03J 5/02

(54) **Dispositif de comparaison de fréquences à faible inertie temporelle**

(30) Priorité: 28.11.2000 FR 0015356
(71) Demandeur: Koninklijke Philips Electronics N.V., 5621 BA Eindhoven (NL)
(72) Inventeur: Canard, David, 75008 Paris (FR); Fillatre, Vincent, 75008 Paris (FR)
(74) Mandataire: Chaffraix, Jean

(57) **Abrégé**

La présente invention concerne un dispositif de comparaison CMP, destiné à délivrer un signal de contrôle Vcnt représentatif d'une différence existant entre les fréquences de signaux d'entrée Vdiv et Vref.

Le dispositif selon l'invention inclut :
. un comparateur de phase/fréquence PD fournissant un signal de réglage Tun, soumis à une modulation de largeur d'impulsion en fonction de la différence observée,
. une source de courant destinée à délivrer un courant de charge Ics ayant une valeur contrôlée par le signal de réglage Tun, et
. un élément capacitif Cs destiné à générer le signal de contrôle Vcnt, sous l'effet du courant de charge Ics.

L'invention permet, au moyen d'un signal de réglage Tun ayant une fréquence pratiquement constante, d'imposer des variations hautes fréquences au signal de contrôle Vcnt

Application : Synthétiseurs de fréquences.

## Description

La présente invention concerne un dispositif de comparaison, destiné à recevoir un premier et un deuxième signal d'entrée et à délivrer un signal de contrôle représentatif d'une différence de fréquence existant entre lesdits signaux.

De tels dispositifs sont couramment utilisés pour contrôler des fréquences d'oscillation de synthétiseurs de fréquences, notamment au sein d'appareils récepteurs de signaux radioélectriques, comme des téléviseurs, des boîtiers-décodeurs ou des radiotéléphones, appareils dans lesquels des conversions de fréquences sont réalisées par mélanges de signaux à convertir avec des signaux de sortie de tels synthétiseurs. Un dispositif de comparaison, destiné à contrôler un synthétiseur de fréquences, est notamment connu du brevet US No. 5,216,374. Ce dispositif est destiné à recevoir, en tant que premier et deuxième signaux d'entrée, un signal de sortie d'un oscillateur et un signal de référence. Le dispositif connu opère au moyen d'un microcontrôleur un calcul de la différence de fréquence existant entre les signaux d'entrée, et génère un signal de contrôle numérique constitué d'une succession d'impulsions ayant une largeur déterminée par le résultat dudit calcul. Le signal de contrôle numérique est ensuite converti en une tension analogique et appliqué à une entrée de contrôle de l'oscillateur afin d'ajuster la fréquence de son signal de sortie. Le dispositif connu met ainsi en oeuvre une circuiterie numérique de structure très complexe, en vue de réaliser une mesure quantitative de la différence de fréquence entre les signaux d'entrée et de traduire le résultat de cette mesure en une modulation de la largeur des impulsions du signal de contrôle. Une telle circuiterie présente de grandes difficultés de conception, du fait notamment de temps de réponse importants induits par sa complexité. De plus, la structure connue est difficilement réalisable sous forme d'un unique circuit intégré, ce qui la rend coûteuse à produire et difficile à utiliser.

La présente invention a pour but de remédier à ces inconvénients en proposant un dispositif de comparaison muni d'une structure très simple, facilement intégrable et dont le temps de réponse est très faible.

En effet un dispositif de comparaison conforme au paragraphe introductif inclut selon l'invention :
. un comparateur de phase/fréquence destiné à recevoir les premier et deuxième signaux d'entrée et à délivrer un signal de réglage,
. au moins une source de courant destinée à délivrer un courant de charge ayant une valeur variable en fonction du signal de réglage, et
. un élément capacitif destiné à être parcouru par ledit courant de charge et à générer le signal de contrôle,
le comparateur de phase/fréquence étant agencé de sorte que le signal de réglage est constitué d'une succession d'impulsions présentant chacune une largeur modulée en fonction de la différence de fréquences existant entre les premier et deuxième signaux d'entrée.

Le dispositif de comparaison selon l'invention ne nécessite pas de mesure quantitative de la différence de fréquence existant entre ses signaux d'entrée. Une telle différence provoque automatiquement une variation de la largeur des impulsions du signal de réglage, variation qui provoque à son tour une variation dans la valeur du courant de charge, à l'instar de ce qui se produit dans les boucles à verrouillage de phase classiques.
L'invention est remarquable en ce qu'elle permet, au moyen d'un signal de réglage ayant une fréquence pratiquement constante, d'imposer des variations hautes fréquences au signal de contrôle grâce à une modulation haute fréquence de la largeur des impulsions du signal de réglage.
Ainsi, une source de courant de construction usuelle est capable de produire, grâce à l'invention, un courant de charge présentant des variations hautes fréquences, sans que ladite source de courant soit elle-même appelée à commuter à de hautes fréquences.

Dans un mode de réalisation particulier de l'invention, le comparateur de phase/fréquence inclut une bascule RS dont des entrées de mise à un et de mise à zéro sont respectivement pilotées par les premier et deuxième signaux d'entrée, et dont une sortie est destinée à délivrer le signal de contrôle.

Dans ce mode de réalisation, avantageux du fait de sa simplicité, la modulation de la largeur des impulsions du signal de réglage est réalisée par la bascule RS, qui est un composant peu coûteux et aisément intégrable.

L'invention sera avantageusement utilisée pour contrôler un synthétiseur de fréquences, incluant :
. un oscillateur destiné à délivrer un signal de sortie ayant une fréquence d'oscillation contrôlée au moyen d'un signal de contrôle, et
. un dispositif de comparaison tel que décrit plus haut, dont les premier et deuxième signaux d'entrée sont respectivement constitués par le signal de sortie de l'oscillateur et un signal de référence, lequel dispositif est destiné à fournir à l'oscillateur son signal de contrôle.

Ainsi qu'exposé plus haut, l'invention concerne également, dans un de ses modes de mise en oeuvre, un appareil destiné à la réception de signaux radioélectriques, incluant :
. un étage d'entrée destiné à recevoir un signal radioélectrique et à convertir ledit signal en un signal de sortie électronique ayant une fréquence dite fréquence radio,
. un synthétiseur de fréquences tel que décrit ci-dessus, destiné à délivrer un signal de sortie ayant une fréquence dite d'oscillation, et
. un mélangeur destiné à recevoir les signaux de sortie de l'étage d'entrée et du synthétiseur de fréquences, et à délivrer un signal ayant une fréquence égale à une différence entre la fréquence radio et la fréquence d'oscillation.

Enfin, de manière plus générale, l'invention concerne une méthode pour contrôler une fréquence d'oscillation d'un oscillateur contrôlé en tension, incluant les étapes suivantes :
. élaboration d'un signal de réglage constitué d'une succession d'impulsions présentant chacune une largeur modulée en fonction d'une différence de fréquences existant entre un premier et un deuxième signal,
. utilisation dudit signal de réglage pour piloter au moins une source de courant destinée à délivrer un courant de charge, et
. utilisation en tant que signal de contrôle d'une tension générée par un élément capacitif parcouru par ledit courant de charge.

L'invention sera mieux comprise à l'aide de la description suivante, faite à titre d'exemple non-limitatif et en regard des dessins annexés, dans lesquels :
- la figure 1 est un schéma fonctionnel partiel décrivant un appareil récepteur de signaux radioélectriques mettant en oeuvre l'invention,
- la figure 2 est un schéma fonctionnel décrivant partiellement un dispositif de comparaison conforme à un mode de réalisation avantageux de l'invention, et
- la figure 3 est un ensemble de chronogrammes décrivant l'évolution de signaux présents dans un tel dispositif.

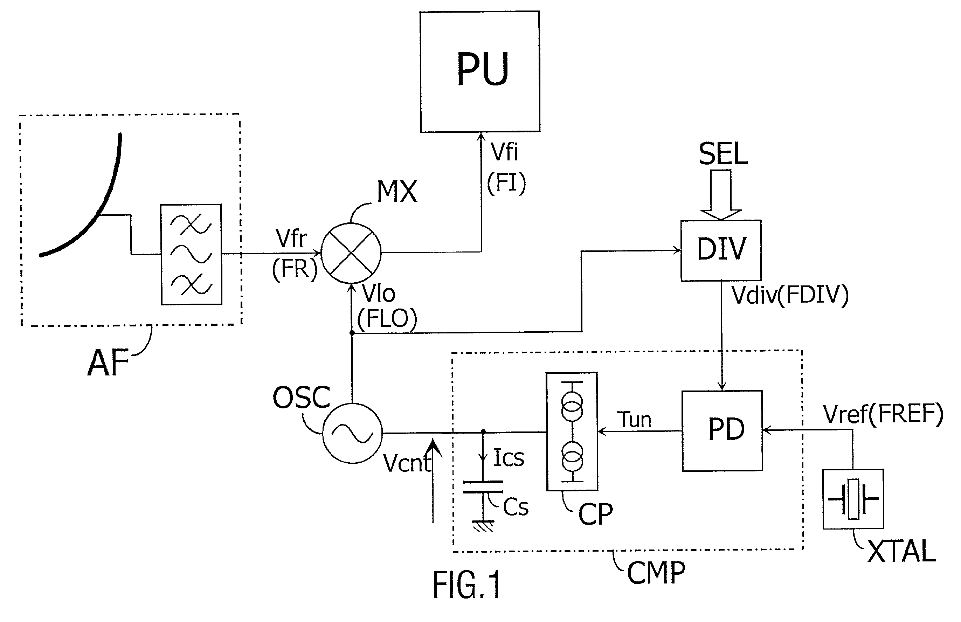

La figure 1 représente schématiquement un appareil récepteur de signaux radioélectriques, par exemple un téléviseur, un boîtier-décodeur ou encore un radiotéléphone. Cet appareil inclut :
. un étage d'entrée AF, dans cet exemple un système d'antenne et de filtrage, destiné à recevoir un signal radioélectrique et à convertir ledit signal en un signal de sortie électronique Vfr ayant une fréquence FR dite fréquence radio,
. un synthétiseur de fréquences (OSC, CMP), destiné à délivrer un signal de sortie Vlo ayant une fréquence FLO dite d'oscillation, et
. un mélangeur MX destiné à recevoir les signaux de sortie Vfr et Vlo de l'étage d'entrée AF et du synthétiseur de fréquences (OSC, CMP), et à délivrer un signal Vfi ayant une fréquence FI, dite intermédiaire et égale à une différence entre la fréquence radio FR et la fréquence d'oscillation FLO.
Selon une technique connue, le choix de la fréquence d'oscillation FLO permet une sélection de la fréquence radio FR. En effet, la valeur de la fréquence intermédiaire FI est rendue fixe par un système de filtrage sélectif, non représenté sur la figure. Ainsi, puisque FI=FR-FLO, on a FR=FI-FLO. Dans l'appareil décrit ici, le synthétiseur de fréquences inclut :
. un oscillateur OSC destiné à délivrer le signal de sortie Vlo du synthétiseur, dont la fréquence d'oscillation FLO est contrôlée au moyen d'un signal de contrôle Vcnt, et
. un dispositif de comparaison CMP conforme à l'invention, dont des premier et deuxième signaux d'entrée sont respectivement constitués par un signal Vdiv dérivé du signal de sortie Vlo de l'oscillateur OSC et un signal de référence Vref, lequel dispositif CMP est destiné à fournir à l'oscillateur OSC son signal de contrôle Vcnt.
Le signal de référence Vref pourra par exemple être généré par un oscillateur à quartz XTAL, dont la fréquence FREF est parfaitement maîtrisée.
Le dispositif de comparaison CMP est construit de sorte que, lorsqu'il détecte une différence entre les fréquences de ses premier et deuxième signaux d'entrée Vdiv et Vref, il provoque une variation du signal de contrôle Vcnt permettant d'ajuster la fréquence d'oscillation FLO de sorte que la différence détectée par le dispositif de comparaison CMP disparaisse.
Dans l'exemple décrit ici, un diviseur de fréquence DIV est inséré entre la sortie de l'oscillateur OSC et le dispositif de comparaison CMP. Ce diviseur de fréquence DIV est destiné à opérer une division entre la fréquence FLO de son signal d'entrée Vlo et la fréquence FDIV de son signal de sortie Vdiv, dont le rapport, noté R, avec R=FLO/FDIV, est déterminé par l'utilisateur de l'appareil au moyen d'un signal de sélection SEL. La présence de ce diviseur de fréquences DIV permet d'introduire un degré de liberté dans le choix de la fréquence d'oscillation FLO, et donc dans la sélection de la fréquence radio FR. En effet, dans un régime d'équilibre, FDIV=FREF, et donc FLO=R.FREF, soit encore FR=FI-R.FREF.
Le dispositif de comparaison CMP décrit dans ce mode de réalisation de l'invention inclut :
. un comparateur de phase/fréquence PD destiné à recevoir les premier et deuxième signaux d'entrée Vdiv et Vref et à délivrer un signal de réglage Tun,
. une pompe de charge CP, incluant deux sources de courant, destinée à délivrer un courant de charge Ics ayant une valeur variable en fonction du signal de réglage Tun, et
. un élément capacitif Cs destiné à être parcouru par ledit courant de charge Ics et à générer le signal de contrôle Vcnt.
Selon l'invention, le comparateur de phase/fréquence PD est agencé de sorte que le signal de réglage Tun est constitué d'une succession d'impulsions présentant chacune une largeur modulée en fonction de la différence de fréquences existant entre les premier et deuxième signaux d'entrée Vdiv et Vref.
Ainsi, lorsque le dispositif de comparaison CMP détectera des différences entre les fréquences de ses signaux d'entrée Vdiv et Vref, le signal de réglage Tun présentera un rapport cyclique, noté K, variable, ce qui provoquera des variations de la valeur du courant de charge Ics, et donc des variations du signal de contrôle Vcnt. Un courant Ics positif provoquera une charge de l'élément capacitif Cs, et une augmentation de la valeur du signal de contrôle Vcnt qui provoquera une augmentation de la fréquence d'oscillation FLO. Inversement, un courant Ics négatif provoquera une décharge de l'élément capacitif Cs, et une diminution de la valeur du signal de contrôle Vcnt qui provoquera une diminution de la fréquence d'oscillation FLO. L'invention est remarquable en ce qu'elle permet, au moyen d'un signal de réglage Tun ayant une fréquence pratiquement constante, d'imposer des variations hautes fréquences au signal de contrôle Vcnt grâce à une modulation haute fréquence de la largeur des impulsions du signal de réglage Tun, et donc du rapport cyclique K dudit signal.
Ainsi, une pompe de charge CP de construction usuelle, notoirement limitée en fréquence, est capable de produire, grâce à l'invention, un courant de charge Ics présentant des variations hautes fréquences, sans que ladite pompe de charge CP soit elle-même appelée à commuter à de hautes fréquences. L'invention permet donc d'augmenter la précision du réglage de la fréquence du signal de sortie d'un synthétiseur, particulièrement à de hautes fréquences, de l'ordre du GigaHertz, sans augmenter de manière significative le coût dudit synthétiseur.
La rapidité de la réponse du dispositif de comparaison CMP selon l'invention est telle qu'il sera avantageux, pour éviter des surcorrections pouvant sérieusement compromettre le régime d'équilibre, d'insérer entre le détecteur de phase/fréquence PD et la pompe de charge CP un filtre passe-bas, destiné à produire un signal représentatif d'une valeur moyenne du signal de réglage Tun.

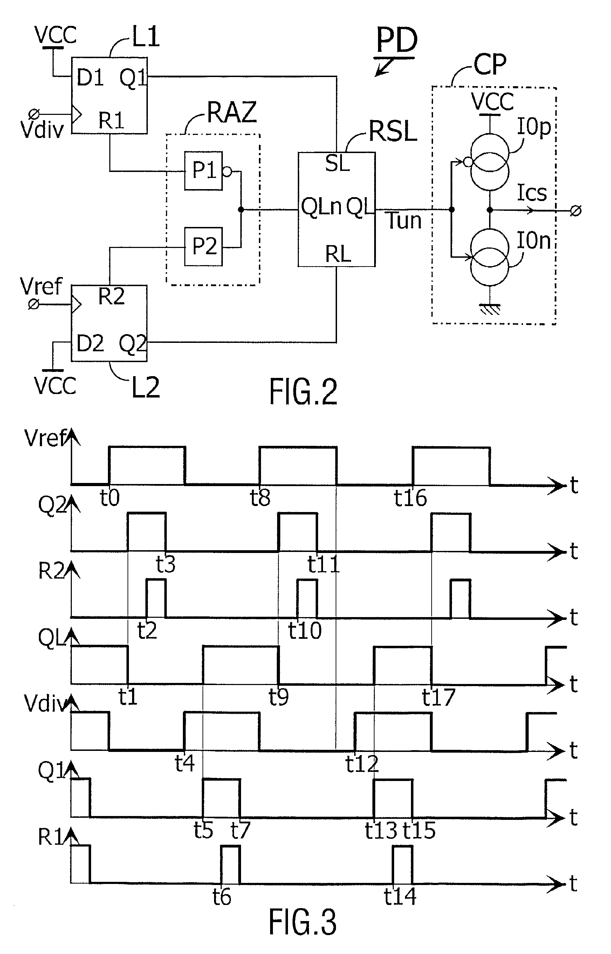

La figure 2 est un schéma fonctionnel qui représente partiellement un dispositif de comparaison conforme à un mode de réalisation particulièrement avantageux de l'invention. Ce dispositif comporte un comparateur de phase/fréquence PD et une pompe de charge CP.
La pompe de charge CP inclut une première et une deuxième source de courant, I0p et I0n, disposées en série entre une borne positive d'alimentation VCC et une masse, et destinées à débiter alternativement un courant I0 en fonction de la valeur du signal de réglage Tun. Un noeud intermédiaire auxdites sources de courant constitue une sortie de la pompe de charge CP, destinée à délivrer un courant de charge Ics qui peut être positif ou négatif. Dans l'exemple décrit ici, la première source de courant I0p sera conductrice lorsque le signal de réglage Tun présentera un niveau logique 0, tandis que la deuxième source de courant I0n sera conductrice lorsque le signal de réglage Tun présentera un niveau logique 1. Les première et deuxième sources de courant I0p et I0n seront alors avantageusement réalisées à base de transistors bipolaires de type de PNP et NPN, respectivement, ou de transistors MOS de type PMOS et NMOS.
Ainsi, le rapport cyclique K du signal de réglage Tun, défini comme le rapport entre la durée pendant laquelle il présente un niveau logique 1 et la durée d'une de ses périodes, détermine la valeur moyenne du courant Ics. En effet, lorsque K=0,5, ladite valeur moyenne du courant Ics est nulle, puisqu'au cours d'une même période, les première et deuxième sources de courant I0p et I0n conduisent pendant des durées égales.
Si K est inférieur à 0,5, la première source de courant I0p conduira plus longtemps que la deuxième source de courant I0n pendant une même période du signal de réglage Tun, et la valeur moyenne du courant de charge Ics sera positive, tandis que si K est supérieur à 0,5, la deuxième source de courant I0n conduira plus longtemps que la première source de courant I0p pendant une même période du signal de réglage Tun, et la valeur moyenne du courant de charge Ics sera négative.
Le comparateur de phase/fréquence PD inclut dans ce mode de réalisation une bascule RS, appelée RSL, dont des entrées de mise à un et de mise à zéro SL et RL sont respectivement pilotées par les premier et deuxième signaux d'entrée Vdiv et Vref, et dont une sortie QL est destinée à délivrer le signal de contrôle Tun. Selon les caractéristiques connues des bascules RS, lorsque l'entrée SL recevra un niveau logique 1, la sortie QL sera placée au niveau logique 1, jusqu'à ce l'entrée RL reçoive à son tour un niveau logique 1, qui aura pour effet de placer la sortie QL au niveau logique 0.
Le comparateur de phase/fréquence PD décrit ici inclut en outre
. un premier et un deuxième détecteur L1 et L2 de fronts actifs des premier et deuxième signaux d'entrée Vdiv et Vref, constitués ici par des bascules mémoire de type bascule D, dont des entrées de données D1 et D2 sont reliées à la borne positive d'alimentation VCC, et dont des sorties Q1 et Q2 sont respectivement reliées aux entrées de mise à un et de mise à zéro SL et RL de la bascule RSL, et
. des moyens de réinitialisation P1 et P2 des premier et deuxième détecteurs L1 et L2, destinés à désactiver l'un ou l'autre desdits détecteurs L1 ou L2lorsque le front actif qu'il a détecté a été pris en compte par la bascule RSL. Une désactivation d'un détecteur L1 ou L2 se traduira dans cet exemple par une mise au niveau logique 0 de sa sortie Q1 ou Q2. Les moyens de réinitialisation pourront par exemple être constitués par des générateurs d'impulsions bien connus de l'homme du métier, dont des sorties seront reliées à des entrées de réinitialisation R1 et R2 des détecteurs L1 et L2.
Dans ce comparateur de phase/fréquence PD, un front actif du premier signal d'entrée Vdiv provoquera un front montant du signal de réglage Tun, tandis qu'un front actif du deuxième signal d'entrée provoquera un front descendant du signal de réglage Tun. Le régime d'équilibre, au cours duquel le rapport cyclique K du signal de réglage Tun sera égal à 0,5, sera donc atteint lorsque les premier et deuxième signaux d'entrée Vdic et Vref seront en opposition de phase.
Il va de soi qu'il est tout à fait envisageable d'inverser le câblage des première et deuxième sources de courant I0p et I0n, ainsi que celui des entrées de mise à un et de mise à zéro SL et RL, sans provoquer de modifications significatives du dispositif de comparaison conforme à l'invention.

La figure 3 illustre sous forme de chronogrammes l'évolution de divers signaux présents dans le dispositif de comparaison décrit ci-dessus.
Le deuxième signal d'entrée du dispositif, matérialisé ici par le signal de référence Vref, est périodique et possède un rapport cyclique constant au cours du temps, égal à 0,5. Dans l'exemple décrit ici, il présente un front montant à un instant t0. A un instant t1, séparé de l'instant t0 par un intervalle de temps tI2 du à l'inertie temporelle du détecteur L2, la sortie Q2 dudit détecteur présente un niveau logique 1, et provoque une remise à zéro de la sortie QL de la bascule RSL, ainsi qu'une mise à un de sa sortie complémentée QLn. A un instant t2, séparé de l'instant t1 par un intervalle de temps tp2 du à l'inertie temporelle du générateur d'impulsions P2, l'entrée de réinitialisation R2 du détecteur reçoit un niveau logique 1, qui provoque, à un instant t3 séparé de l'instant t2 par l'intervalle de temps tI2 du à l'inertie temporelle du détecteur L2, une désactivation dudit détecteur L2, la sortie QL de la bascule RSL restant au niveau logique 0.
Le deuxième signal d'entrée du dispositif de comparaison, matérialisé ici par le signal de sortie du diviseur de fréquence Vdiv, est variable. Dans l'exemple décrit ici, il est, au cours d'une première période, en opposition de phase avec le signal de référence Vref, c'est-à-dire qu'un régime d'équilibre a été atteint. Le signal Vdiv présente un front montant à un instant t4. A un instant t5, séparé de l'instant t4 par un intervalle de temps tl1 du à l'inertie temporelle du détecteur L1, la sortie Q1 dudit détecteur présente un niveau logique 1, et provoque une mise à un de la sortie QL de la bascule RSL, ainsi qu'une mise à zéro de sa sortie complémentée QLn. A un instant t6, séparé de l'instant t5 par un intervalle de temps tp1 du à l'inertie temporelle du générateur d'impulsions P1, l'entrée de réinitialisation R1 du détecteur reçoit un niveau logique 1, qui provoque, à un instant t7 séparé de l'instant t6 par l'intervalle de temps tl1 du à l'inertie temporelle du détecteur L1, une désactivation dudit détecteur L1, la sortie QL de la bascule RSL restant au niveau logique 1. A un instant t8, le deuxième signal d'entrée Vref présente à nouveau un front montant, provoquant, selon les explications données ci-dessus, une mise à un à un instant t9 de la sortie Q2 du détecteur L2, et donc une remise à zéro de la sortie QL de la bascule RSL.
On observe ainsi que le rapport cyclique K du signal Tun délivré par la sortie QL de la bascule RSL est égal à (t9-t5)/(t9-t1), soit K=0,5, lorsque les premier et deuxième signaux d'entrée Vdiv et Vref du dispositif de comparaison sont en opposition de phase. Dans une telle situation, qui correspond au régime d'équilibre, la valeur moyenne du courant de charge Ics est nulle, et aucune correction n'est apportée à la fréquence d'oscillation.
La présente figure permet en outre d'observer la réaction du dispositif de comparaison dans une situation où ses premier et deuxième signaux d'entrée ne sont plus en opposition de phase. En effetn dans l'exemple décrit ici, le premier signal d'entrée Vdiv présente un front montant à l'instant t12, en retard par rapport à l'instant où le deuxième signal d'entrée Vref présente un front descendant, ce qui signifie que la fréquence du premier signal d'entrée Vdiv devient trop faible. On constate qu'à l'issue d'une séquence d'évènements similaire à celle décrite plus haut, la sortie QL de la bascule RSL est au niveau logique 1 pendant un intervalle de temps (t17-t13) de durée inférieure à l'intervalle de temps (t9-t5). Au cours de cette période (t17-t9), le rapport cyclique du signal de réglage Tun devient donc inférieur à 0,5, ce qui implique que le courant de charge Ics délivré par la pompe de charge CP aura une valeur moyenne positive tant que la fréquence du premier signal d'entrée Vdiv sera inférieure à celle du deuxième signal d'entrée Vref, provoquant ainsi une charge de l'élément capacitif, résultant en un accroissement de la valeur du signal de contrôle prélevé à ses bornes en vue d'une augmentation de la valeur de la fréquence dudit premier signal Vdiv afin de retrouver le régime d'équilibre.

## Revendications

1. Dispositif de comparaison, destiné à recevoir un premier et un deuxième signal d'entrée et à délivrer un signal de contrôle représentatif d'une différence de fréquence existant entre lesdits signaux, dispositif incluant :
. un comparateur de phase/fréquence destiné à recevoir les premier et deuxième signaux d'entrée et à délivrer un signal de réglage,
. au moins une source de courant destinée à délivrer un courant de charge ayant une valeur variable en fonction du signal de réglage, et
. un élément capacitif destiné à être parcouru par ledit courant de charge et à générer le signal de contrôle,
dispositif dans lequel le comparateur de phase/fréquence est agencé de sorte que le signal de réglage est constitué d'une succession d'impulsions présentant chacune une largeur modulée en fonction de la différence de fréquences existant entre les premier et deuxième signaux d'entrée.

2. Dispositif de comparaison selon la revendication 1, dans lequel le comparateur de phase/fréquence inclut une bascule RS dont des entrées de mise à un et de mise à zéro sont respectivement pilotées par les premier et deuxième signaux d'entrée, et dont une sortie est destinée à délivrer le signal de contrôle.

3. Dispositif de comparaison selon la revendication 1, dans lequel le comparateur de phase/fréquence inclut :
. un premier et un deuxième détecteur de fronts actifs des premier et deuxième signaux d'entrée, respectivement, dont des sorties sont reliées aux entrées de mise à un et de mise à zéro de la bascule RS, et
. des moyens de réinitialisation des premier et deuxième détecteurs, destinés à désactiver l'un ou l'autre desdits détecteurs lorsque le front actif qu'il a détecté a été pris en compte par la bascule RS.

4. Synthétiseur de fréquences, incluant :
. un oscillateur destiné à délivrer un signal de sortie ayant une fréquence d'oscillation contrôlée au moyen d'un signal de contrôle, et
. un dispositif de comparaison conforme à la revendication 1, dont les premier et deuxième signaux d'entrée sont respectivement constitués par le signal de sortie de l'oscillateur et un signal de référence, lequel dispositif est destiné à fournir à l'oscillateur son signal de contrôle.

5. Synthétiseur de fréquences selon la revendication 4, incluant en outre un diviseur programmable inséré entre l'oscillateur et le dispositif de comparaison.

6. Appareil destiné à la réception de signaux radioélectriques, incluant :
. un étage d'entrée destiné à recevoir un signal radioélectrique et à convertir ledit signal en un signal de sortie électronique ayant une fréquence dite fréquence radio,
. un synthétiseur de fréquences conforme à la revendication 4, destiné à délivrer un signal de sortie ayant une fréquence dite d'oscillation, et
. un mélangeur destiné à recevoir les signaux de sortie de l'étage d'entrée et du synthétiseur de fréquences, et à délivrer un signal ayant une fréquence égale à une différence entre la fréquence radio et la fréquence d'oscillation.

7. Méthode pour contrôler une fréquence d'oscillation d'un oscillateur contrôlé en tension, incluant les étapes suivantes :
. élaboration d'un signal de réglage constitué d'une succession d'impulsions présentant chacune une largeur modulée en fonction d'une différence de fréquences existant entre un premier et un deuxième signal,
. utilisation dudit signal de réglage pour piloter au moins une source de courant destinée à délivrer un courant de charge, et
. utilisation en tant que signal de contrôle d'une tension générée par un élément capacitif parcouru par ledit courant de charge.
